# EUROPEAN PATENT APPLICATION

(11) **EP 4 039 645 A1**
(43) Date of publication of application: **10.08.2022**
(21) Application number: 20871245.5
(22) Date of filing: 25.09.2020
(51) Int. Cl.: C01G 15/00, C09C 1/62, C09C 3/06, C09D 11/037, C09D 11/322

(54) **SCALY COMPOSITE PARTICLES, PRODUCTION METHOD THEREFOR, INK, COATING FILM, AND PRINTED MATTER**

(30) Priority: 02.10.2019 JP 2019182236
(71) Applicant: OIKE & Co., Ltd., Kyoto-shi, Kyoto 601-8123 (JP)
(72) Inventor: KAMEI, Akika, Kyoto-shi, Kyoto 601-8122 (JP)
(74) Representative: Graf von Stosch Patentanwaltsgesellschaft mbH
(86) International application number: PCT/JP2020/036402
(87) International publication number: WO 2021/065741

(57) **Abstract**

Provided are scaly composite particles, including an indium layer, and a transparent inorganic layer on at least one surface of the indium layer. The transparent inorganic layer is an inorganic oxide, and has an average thickness of less than 25 nm. The scaly composite particles have a cumulative 50% volume-based particle diameter D₅₀ of 1 µm or greater but 20 µm or less.

## Description

### Technical Field

The present invention relates to scaly composite particles and a method for producing scaly composite particles, an ink, a coating film, and a printed matter.

### Background Art

In recent years, along with a remarkable technological progress in water-based paints and water-based inks, water-based paints and water-based inks have also been becoming able to realize a luxurious finish appearance that hitherto has been achieved only with solvent paints and solvent inks.

For example, PTL 1 attempts to add thin leaf-like aluminum particles in water-based paints and water-based inks with a view to imparting a metallic gloss. However, when thin leaf-like aluminum particles are mixed in water-based paints and water-based inks, there is a problem that the thin leaf-like aluminum particles may undergo reaction with water contained in the paints and the inks, to blacken or emit a hydrogen gas, to thereby degrade storage stability of the water-based paints and the water-based inks.

### Citation List

### Patent Literature

PTL 1: Japanese Patent Application Laid-Open (JP-A) No. 2012-162638

### Summary of Invention

### Technical Problem

The present invention aims for solving the various problems in the related art and achieving an object described below. That is, the present invention has an object to provide scaly composite particles that have a large particle diameter, are free of coloring, and can produce a printed matter having an excellent metallic gloss even when used in water-based paints and water-based inks, a method for producing scaly composite particles, an ink, a coating film, and a printed matter.

### Solution to Problem

Means for solving the above problems are as follows.
<1> Scaly composite particles, including:
   an indium layer; and
   a transparent inorganic layer on at least one surface of the indium layer,
   wherein the transparent inorganic layer is an inorganic oxide, and has an average thickness of less than 25 nm, and
   the scaly composite particles have a cumulative 50% volume-based particle diameter D₅₀ of 1 µm or greater but 20 µm or less.
<2> The scaly composite particles according to <1>,
   wherein an arithmetic mean roughness Ra of a surface of the transparent inorganic layer is 15 nm or less.
<3> The scaly composite particles according to <1> or <2>,
   wherein the inorganic oxide is silicon oxide.
<4> The scaly composite particles according to any one of <1> to <3>,
   wherein the indium layer has a sea-island structure, and has an average thickness of 10 nm or greater but 100 nm or less.
<5> A method for producing scaly composite particles, the method including:
   forming a release layer on a base material, obtaining a laminate on the release layer, the laminate including: an indium layer; and a transparent inorganic layer laminated on at least one surface of the indium layer by a vapor deposition method, subsequently releasing the laminate from the base material, and grinding the laminate, to thereby produce scaly composite particles in which the transparent inorganic layer is an inorganic oxide and has an average thickness of less than 25 nm, the scaly composite particles having a cumulative 50% volume-based particle diameter D₅₀ of 1 µm or greater but 20 µm or less.
<6> The method for producing scaly composite particles according to <5>,
   wherein in obtaining the laminate, the indium layer is formed on the release layer, and the transparent inorganic layer is laminated on a surface of the indium layer by the vapor deposition method.
<7> The method for producing scaly composite particles according to <5>,
   wherein in obtaining the laminate, the transparent inorganic layer is formed on the release layer by the vapor deposition method, and the indium layer is laminated on a surface of the transparent inorganic layer.
<8> The method for producing scaly composite particles according to <5>,
   wherein in obtaining the laminate, a first transparent inorganic layer is formed on the release layer by the vapor deposition method, the indium layer is formed on the first transparent inorganic layer, and a second transparent inorganic layer is formed on the indium layer by the vapor deposition method.
<9> The method for producing scaly composite particles according to any one of <5> to <8>,
   wherein the vapor deposition method is a physical vapor deposition method.
<10> An ink, including:
   the scaly composite particles according to any one of <1> to <4>.
<11> The ink according to <10>,
   wherein the ink is used in any printing method selected from the group consisting of an inkjet method, a gravure coating method, a screen printing method, and a spray painting method.
<12> A coating film, including:
   scaly composite particles, including:
   an indium layer; and
   a transparent inorganic layer on at least one surface of the indium layer,
   wherein the transparent inorganic layer is an inorganic oxide, and has an average thickness of less than 25 nm, and
   the scaly composite particles have a cumulative 50% volume-based particle diameter D₅₀ of 1 µm or greater but 20 µm or less.
<13> A printed matter, including:
   a base; and
   the coating film according to <12> on the base.

### Advantageous Effects of Invention

The present invention can solve the various problems in the related art, achieve the object described above, and provide scaly composite particles that have a large particle diameter, are free of coloring, and can produce a printed matter having an excellent metallic gloss even when used in water-based paints and water-based inks, a method for producing scaly composite particles, an ink, a coating film, and a printed matter.

### Brief Description of Drawings

FIG. 1A is a view illustrating an embodiment of the configuration of scaly composite particles of the present invention;
FIG. 1B is a view illustrating an embodiment of the configuration of scaly composite particles of the present invention;
FIG. 1C is a view illustrating an embodiment of the configuration of scaly composite particles of the present invention;
FIG. 2 is a SEM image of a coating film including scaly composite particles of Example 11;
FIG. 3 is a SEM image of a coating film including scaly composite particles of Example 17;
FIG. 4 is a SEM image of a coating film including scaly composite particles of Example 19;
FIG. 5 is a SEM image of a cross-section of a coating film including scaly composite particles of Example 11;
FIG. 6 is a SEM image of a cross-section of a coating film including scaly composite particles of Example 17;
FIG. 7 is a SEM image of a cross-section of a coating film including scaly composite particles of Example 19; and
FIG. 8 is a correlation chart between cumulative 50% volume-based particle diameter D₅₀ and gloss value in Examples of the present invention.

### Description of Embodiments

### (Scaly composite particles)

Scaly composite particles of the present invention include an indium layer, and a transparent inorganic layer on at least one surface of the indium layer, and further include other layers as needed. The transparent inorganic layer is an inorganic oxide, and has an average thickness of less than 25 nm. The scaly composite particles have a cumulative 50% volume-based particle diameter D₅₀ of 1 µm or greater but 20 µm or less.

Existing techniques produce scaly indium particles by vapor-depositing indium on a base material to obtain an indium vapor-deposited film, subsequently releasing the indium vapor-deposited film, and grinding the indium vapor-deposited film. Therefore, the indium vapor-deposited film has a sea-island structure including island portions containing indium, and sea portions free of indium and present at grain boundaries between the island portions, i.e., at the gaps between adjoining island portions. When the indium vapor-deposited film is released and ground, it breaks along the sea portions constituting the grain boundaries between the island portions, into the individual island portions. As a result, existing techniques have only succeeded in obtaining scaly indium particles that have a particle diameter of about 0.1 µm at most. Inks containing such scaly indium particles having a small particle diameter have not been able to produce printed matters having a metallic gloss, because the binder component of the inks inhibits the array of the scaly indium particles in the coating film.

Hence, the present invention combines the transparent inorganic film on at least one surface of the indium layer. This makes it possible to form the scaly composite particles having a large particle diameter represented by a cumulative 50% volume-based particle diameter D₅₀ of 1 µm or greater but 20 µm or less, and obtain a highly glossy printed matter. Moreover, by providing the transparent inorganic layer on the surface of the indium layer, it is possible to moderate the roughness of the surface of the indium layer, and obtain the scaly composite particles having a flat surface, making it possible to provide a printed matter having an excellent metallic gloss.

### <Indium layer>

The indium layer is substantially formed of indium, and preferably contains indium having a purity of 95% or higher.

The indium layer can be suitably produced by a method for producing scaly composite particles of the present invention described below.

Here, the formation of the indium layer is inferred as follows. According to a physical vapor deposition method, when individual indium atoms flying from the vapor deposition source reach the surface of the base material, a plurality of indium atoms gather on the surface of the base material and form stereoscopic clusters, and atoms reaching the substrate one after another are absorbed into the clusters and join, to form three-dimensional indium nuclei. When film deposition is continued, the nuclei grow instead of increasing in number. Small nuclei, even if formed, evaporate again, or creep to be absorbed into larger nuclei. Larger nuclei gradually increase in size and grow, to form indium islands. When such island portions are formed, sea portions free of indium are simultaneously formed at the grain boundaries between the island portions, i.e., at the gaps between adjoining island portions. In this way, an indium film having a sea-island structure is formed. Then, when film deposition is continued, large nuclei or islands come to contact each other, to form a meshed continuous film in which the islands link to each other. When film deposition is further continued, the mesh pores become gradually small, to form a thoroughly uniform film.

Such a sea-island structure is maintained for so long as it is on the base material. Therefore, by releasing the indium film having the sea-island structure from the base material and grinding it, it is possible to obtain the indium particles.

However, by providing a transparent inorganic layer on at least one surface of the indium layer, the present invention can prevent breakage into individual island portions of the sea-island structure, i.e., into indium particles, and can form the scaly composite particles including a plurality of island portions and having a large particle diameter.

The shape of the island portions of the sea-island structure may be any shape such as a spherical shape, a bar shape, and a layer shape.

The average thickness of the indium layer is not particularly limited, may be appropriately selected depending on the intended purpose, and is preferably 10 nm or greater but 100 nm or less, more preferably 10 nm or greater but 80 nm or less, and particularly preferably 10 nm or greater but 60 nm or less. When the average thickness of the indium layer is less than 10 nm, the indium layer appears black and cannot have glossiness. On the other hand, when the average thickness of the indium layer becomes greater than 100 nm, the indium layer grows out of the sea-island structure and becomes a continuous film, and it becomes no longer necessary to form a transparent inorganic layer in order to make the particles large in particle diameter.

When the indium layer is produced by, for example, a physical vapor deposition method, the average thickness of the indium layer is the same as an average vapor deposition thickness obtained by measuring the thickness of an indium vapor-deposited thin film at from five to ten positions thereof, and averaging the measurements.

Examples of the method for measuring the average thickness include observation with a scanning electron microscope (SEM), a fluorescent X-ray analysis method (XRF), and ultraviolet-visible spectroscopy.

When obtaining the average thickness by the observation with a scanning electron microscope (SEM), a cross-section of the indium vapor-deposited thin film is observed with the scanning electron microscope (SEM), to measure the thickness of the indium vapor-deposited thin film at from five to ten positions thereof and average the measurements. The average vapor deposition thickness thus obtained may be used as the average thickness.

When obtaining the average thickness by the fluorescent X-ray analysis method (XRF), the thickness of the indium vapor-deposited film is measured at from five to ten positions thereof by a quantitative analysis, and the measurements may be averaged. The average thus obtained may be used as the average thickness.

When obtaining the average thickness by the ultraviolet-visible spectroscopy, the reflectance of the indium vapor-deposited film is measured at from five to ten positions thereof with an ultraviolet-visible spectrophotometer, the thickness of the indium vapor-deposited film is calculated from the spectra of the obtained reflectance measurements, and the obtained values are averaged. The average thus obtained may be used as the average thickness.

### <Transparent inorganic layer>

The transparent inorganic layer is not particularly limited so long as it is transparent, and is preferably colorless and transparent. When the transparent inorganic layer is colorless and transparent, the indium layer can express its unique hue. Here, "colorless and transparent" means a material through which light can be transmitted, and that has no color. It is at least necessary that the transparent inorganic layer have transparency of a level at which metallic gloss of the indium layer is not inhibited.

The material of the transparent inorganic layer is not particularly limited and may be appropriately selected depending on the intended purpose so long as the material can form a transparent, inorganic layer. Examples of the material of the transparent inorganic layer include: inorganic oxides such as silicon oxide (SiOₓ, X≤2) and aluminum oxide (Al₂O₃); and zinc sulfide (ZnS), and magnesium fluoride (MgF₂). Among these materials, SiOₓ is preferable because the scaly composite particles can have a large particle diameter and a high gloss value even when the transparent inorganic layer is formed extremely thin.

The arithmetic mean roughness Ra of the surface of the transparent inorganic layer is not particularly limited, may be appropriately selected depending on the intended purpose, and is preferably 15 nm or less, and more preferably 11 nm or less. When Ra is 15 nm or less, the scaly composite particles have no flaw in the surface thereof, and can be formed as a film having a smooth surface.

The arithmetic mean roughness Ra of the surface of the transparent inorganic layer means an arithmetic mean roughness Ra of a surface profile (roughness curve) according to a contour curve method stipulated by JIS B0601:2013.

The roughness curve is a contour curve obtained by cutting off a long-wavelength component from a profile curve using a wideband filter having a cutoff value.

The arithmetic mean roughness Ra means the average of absolute values of height measurements obtained from a profile curve within a reference length.

The measuring instrument for measuring the arithmetic mean roughness Ra of the surface of the transparent inorganic layer is not particularly limited and may be appropriately selected depending on the intended purpose. Examples of the measuring instrument include a scanning probe microscope (AFM, available from Shimadzu Corporation, SPM-9600).

The average thickness of the transparent inorganic layer is not particularly limited, may be appropriately selected depending on the intended purpose, and is preferably 50 nm or less, more preferably less than 25 nm, and yet more preferably 20 nm or less. When the average thickness of the transparent inorganic layer is 50 nm or less, the transparent inorganic layer can be suppressed from being colored depending on the material of the transparent inorganic layer, and can maintain transparency without degrading the inherent glossiness of the indium layer. Specifically, when the transparent inorganic layer is SiOₓ, the average thickness of the transparent inorganic layer is less than 25 nm in terms of coloring. When the transparent inorganic layer is Al₂O₃, ZnS, or MgF₂, the average thickness of the transparent inorganic layer is preferably 50 nm or less in terms of coloring.

The method for obtaining the average thickness of the transparent inorganic layer may be the same as the method for obtaining the average thickness of the indium layer.

### <Other layers>

Examples of the layer layers include a release layer that is configured to dissolve and thereby release a laminate including the indium layer and the transparent inorganic layer from a base material.

The composite particles of the present invention are scaly. The scaly composite particles may also be referred to as, for example, thin leaf-like particles, flat plate-like particles, and flaky particles.

In the present invention, the scaly composite particles mean particles having an approximately flat surface and an approximately uniform thickness in a direction perpendicular to the approximately flat surface.

The shape of the approximately flat surface is not particularly limited and may be approximately selected depending on the intended purpose. Examples of the shape of the approximately flat surface include an approximately circular shape, an approximately elliptical shape, polygonal shapes such as an approximately triangular shape, an approximately quadrangular shape, an approximately pentagonal shape, an approximately hexagonal shape, an approximately heptagonal shape, and an approximately octagonal shape, and a random irregular shape. Among these shapes, an approximately circular shape is preferable.

The cumulative 50% volume-based particle diameter D₅₀ of the scaly composite particles is 1 µm or greater but 20 µm or less.

When the cumulative 50% volume-based particle diameter D₅₀ of the scaly composite particles is 1 µm or greater but 20 µm or less, the scaly composite particles can realize a large particle diameter while maintaining the indium sea-island structure. Therefore, a printed matter having an excellent metallic gloss can be obtained.

The cumulative 50% volume-based particle diameter D₅₀ is a particle diameter when volume-based distribution is cumulated to 50% in a particle diameter distribution curve obtained by a laser diffraction method, and is a length obtained by taking the average of the longer diameter and the shorter diameter of a scaly composite particle measured when the scaly composite particle, which is non-spherical, is assumed to be a perfect sphere. However, actual scaly composite particles are not spherical but have a scaly shape having a longer side and a shorter side. Hence, D₅₀ is a value different from the actual length of the scaly composite particles in the longer side direction (longer diameter) and the actual length of the scaly composite particles in the shorter side direction (shorter diameter).

Examples of units that utilize the laser diffraction method include a laser diffraction/scattering particle size analyzer.

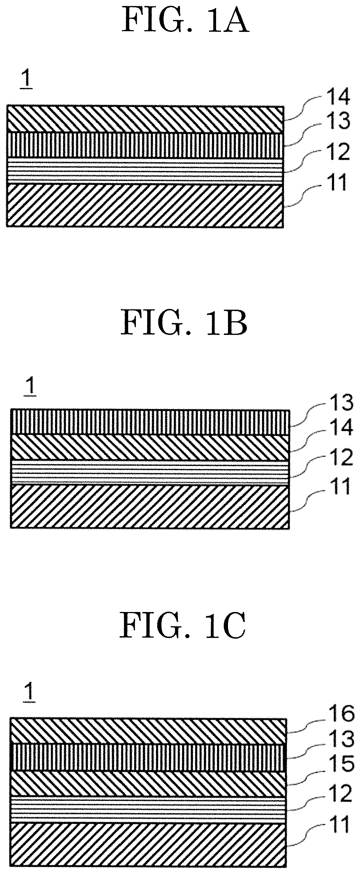

The scaly composite particles have a laminate structure, and specifically have the formations illustrated in FIG. 1A to FIG. 1C. FIG. 1A illustrates a laminate structure of a scaly composite particle 1 including a base material 11, a release layer 12, an indium layer 13, and a transparent inorganic layer 14 laminated in this order. FIG. 1B illustrates a laminate structure of a scaly composite particle 1 including a base material 11, a release layer 12, a transparent inorganic layer 14, and an indium layer 13 laminated in this order. FIG. 1C illustrates a laminate structure of a scaly composite particle 1 including a base material 11, a release layer 12, a first transparent inorganic layer 15, an indium layer 13, and a second transparent inorganic layer 16 laminated in this order. The first transparent inorganic layer 15 and the second transparent inorganic layer 16 may be formed of the same material or may be formed of different materials.

### (Method for producing scaly composite particles)

A method for producing scaly composite particles of the present invention is a method including forming a release layer on a base material, obtaining a laminate on the release layer, the laminate including: an indium layer; and a transparent inorganic layer laminated on at least one surface of the indium layer by a vapor deposition method, subsequently releasing the laminate from the base material, and grinding the laminate, to thereby produce scaly composite particles in which the transparent inorganic layer is an inorganic oxide and has an average thickness of less than 25 nm, the scaly composite particles having a cumulative 50% volume-based particle diameter D₅₀ of 1 µm or greater but 20 µm or less.

It is preferable that the method for producing scaly composite particles of the present invention form the indium layer on the release layer, and laminate the transparent inorganic layer on a surface of the indium layer by a vapor deposition method, to thereby obtain the laminate. This enables efficient production of the scaly composite particles as illustrated in FIG. 1A.

It is preferable that the method for producing scaly composite particles of the present invention form the transparent inorganic layer on the release layer by a vapor deposition method, and laminate the indium layer on a surface of the transparent inorganic layer, to thereby obtain the laminate. This enables efficient production of the scaly composite particles as illustrated in FIG. 1B.

It is preferable that the method for producing scaly composite particles of the present invention form a first transparent inorganic layer on the release layer, form the indium layer on the first transparent inorganic layer, and form a second transparent inorganic layer on the indium layer, to thereby obtain the laminate. This enables efficient production of scaly composite particles as illustrated in FIG. 1C.

In the vapor deposition method, the indium layer and the transparent inorganic layer are formed on a release layer provided on a base material by a vapor deposition method generically referred to as a physical vapor deposition (PVD) method or a sputtering method.

More specifically, the method for producing scaly composite particles of the present invention includes a release layer forming step of providing a release layer on a base material, a laminated film forming step of laminating an indium layer and a transparent inorganic layer on the release layer by a vapor deposition method according to any of the formations illustrated in FIG. 1A to FIG. 1C, to obtain a laminate, a releasing step of dissolving the release layer to release the laminate, and a grinding step of grinding the laminate in a manner to obtain a cumulative 50% volume-based particle diameter D₅₀ of 1 µm or greater but 20 µm or less, and further includes other steps as needed.

### <Release layer forming step>

The release layer forming step is a step of providing the release layer on the base material.

### -Base material-

The base material is not particularly limited so long as the base material has a smooth surface. Various kinds of base materials may be used. Among the various kinds of base materials, resin films, metals, and composite films of metals and resin films that have flexibility, heat resistance, solvent resistance, and dimensional stability may be appropriately used.

Examples of the resin films include polyester films, polyethylene films, polypropylene films, polystyrene films, and polyimide films. Examples of the metals include copper foils, aluminum foils, nickel foils, iron foils, and alloy foils. Examples of the composite films of the metals and the resin films include laminated products of the resins films and the metals.

### -Release layer

The release layer may contain various kinds of organic materials that can be dissolved in the subsequent releasing step, and a solvent such as water. It is preferable to appropriately select the organic material constituting the release layer, because any organic material that has adhered to or has been left on the indium layer or the transparent inorganic layer can be made to function as a protective layer for the scaly composite particles.

The protective layer has a function of suppressing aggregation of the scaly composite particles, oxidation of the scaly composite particles, and elution of the scaly composite particles into a solvent. It is particularly preferable to use the organic material used in the release layer as the protective layer, because it is unnecessary to separately provide a surface treatment step.

Examples of the organic material that constitutes the release layer and can be used as the protective layer include cellulose acetate butyrate (CAB) and other cellulose derivatives, polyvinyl alcohol, polyvinyl butyral, polyethylene glycol, polyacrylic acid, polyacrylamide, acrylic acid copolymers, and modified nylon resins. One of these organic materials may be used alone or two or more of these organic materials may be used in combination. Among these organic materials, cellulose acetate butyrate (CAB) is preferable because of its high functionality as the protective layer.

The method for forming the release layer is not particularly limited and may be appropriately selected depending on the intended purpose. Examples of the method include an inkjet method, a blade coating method, a gravure coating method, a gravure offset coating method, a bar coating method, a roll coating method, a knife coating method, an air knife coating method, a comma coating method, a U-comma coating method, an AKKU coating method, a smoothing coating method, a micro-gravure coating method, a reverse roll coating method, a 4-roll coating method, a 5-roll coating method, a dip coating method, a curtain coating method, a slide coating method, and a die coating method. One of these methods may be used alone or two or more of these methods may be used in combination.

### <Laminated film forming step>

The laminated film forming step is a step of forming films in a manner to obtain the laminate by laminating the indium layer and the transparent inorganic layer on the release layer according to any of the formations illustrated in FIG. 1A to FIG. 1C.

The indium layer and the transparent inorganic layer can be formed by various methods such as a vapor deposition method and a sputtering method.

### <Releasing step>

The releasing step is a step of dissolving the release layer to thereby release the laminate.

The solvent that can dissolve the release layer is not particularly limited and may be appropriately selected depending on the intended purpose so long as the solvent is a solvent that can dissolve the release layer.

The solvent that can dissolve the release layer is not particularly limited and may be appropriately selected depending on the intended purpose. Examples of the solvent include: alcohols such as methanol, ethanol, propanol, isopropanol, butanol, octanol, dodecanol, ethylene glycol, and propylene glycol; ethers such as tetrahydron; ketones such as acetone, methyl ethyl ketone, and acetyl acetone; esters such as methyl acetate, ethyl acetate, butyl acetate, and phenyl acetate; glycol ethers such as ethyl cellosolve, butyl cellosolve, ethyl carbitol, butyl carbitol, ethylene glycol monomethyl ether, ethylene glycol monoethyl ether, ethylene glycol monoisopropyl ether, ethylene glycol monobutyl ether, ethylene glycol monohexyl ether, ethylene glycol monophenyl ether, diethylene glycol monomethyl ether, diethylene glycol monoethyl ether, diethylene glycol monobutyl ether, diethylene glycol dimethyl ether, diethylene glycol diethyl ether, triethylene glycol monomethyl ether, triethylene glycol monoethyl ether, triethylene glycol monobutyl ether, propylene glycol monomethyl ether, propylene glycol monoethyl ether, dipropylene glycol monomethyl ether, dipropylene glycol monoethyl ether, and diethylene glycol monomethyl ether acetate; phenols such as phenol and cresol; aliphatic or aromatic hydrocarbons such as pentane, hexane, heptane, octane, dodecane, tridecane, tetradecane, pentadecane, hexadecane, octadecane, octadecene, benzene, toluene, xylene, trimesin, nitrobenzene, aniline, and methoxybenzene; aliphatic or aromatic hydrocarbon chlorides such as dichloromethane, chloroform, trichloroethane, chlorobenzene, and dichlorobenzene; sulfur-containing compounds such as dimethyl sulfoxide; nitrogen-containing compounds such as dimethyl formamide, dimethyl acetamide, acetonitrile, propionitrile, and benzonitrile; and water. One of these solvents may be used alone or two or more of these solvents may be used in combination.

### <Grinding step>

The grinding step is a step of grinding the laminate released from the base material in the releasing step.

The method used in the grinding step is not particularly limited and may be appropriately selected depending on the intended purpose. Examples of the method include a jet mill, a ball mill, a bead mill, a vibration mill, and an ultrasonic homogenizer.

Moreover, various treatments may further be performed as needed in order to recover the scaly composite particles or adjust the properties of the scaly composite particles. For example, the particle size of the scaly composite particles may be adjusted by classification, or the scaly composite particles may be recovered by such methods as centrifugation and suction filtration, or the solid concentration of a dispersion liquid may be adjusted. Moreover, the solvent may be displaced, or the viscosity may be adjusted using an additive.

### <Other steps>

Examples of the other steps include a step of extracting the ground scaly composite particles in the form of a dispersion liquid, and a step of recovering the scaly composite particles from the dispersion liquid.

### (Ink)

An ink of the present invention contains the scaly composite particles of the present invention, preferably contains water, an organic solvent, and a binder, and further contains other components as needed.

The ink of the present invention may be either water-based or solvent-based. In terms of environment, a water-based ink is preferable. Because indium contained in the scaly composite particles has water stability, it is suitable to use the scaly composite particles in a water-based ink.

### -Scaly composite particles-

The ink of the present invention may contain a glitter pigment other than the scaly composite particles as needed. Examples of the other glitter pigment include a metal pigment (for example, an aluminum pigment), a pigment obtained from natural mica (for example, a pearl pigment), and a glass flake pigment.

The content of the scaly composite particles is not particularly limited, may be appropriately selected depending on the intended purpose, and is preferably 0.1% by mass or greater but 20.0% by mass or less relative to the total amount of the ink.

### -Water-

As the water, for example, pure water such as ion-exchanged water, ultrafiltrated water, reverse osmotic water, and distilled water, or ultrapure water may be used.

The content of the water is preferably 1% by mass or greater but 90% by mass or less relative to the total amount of the ink.

### -Organic solvent-

The organic solvent is not particularly limited and may be appropriately selected depending on the intended purpose. Examples of the organic solvent include polyvalent alcohols, polyvalent alcohol alkyl ethers, polyvalent alcohol aryl ethers, nitrogen-containing heterocyclic compounds, amides, amines, and sulfur-containing compounds. One of these organic solvents may be used alone or two or more of these organic solvents may be used in combination.

Examples of the polyvalent alcohols include ethylene glycol, diethylene glycol, 1,2-propanediol, 1,3-propanediol, 1,2-butanediol, 1,3-butanediol, 1,4-butanediol, 2,3-butanediol, 3-methyl-1,3-butanediol, triethylene glycol, polyethylene glycol, polypropylene glycol, 1,2-pentanediol, 1,3-pentanediol, 1,4-pentanediol, 2,4-pentanediol, 1,5-pentanediol, 1,2-hexanediol, 1,6-hexanediol, 1,3-hexanediol, 2,5-hexanediol, 1,5-hexanediol, glycerin, 1,2,6-hexanetriol, 2-ethyl-1,3-hexanediol, ethyl-1,2,4-butanetriol, 1,2,3-butanetriol, and 2,2,4-trimethyl-1,3-pentanediol.

Examples of the polyvalent alcohol alkyl ethers include ethylene glycol monoethyl ether, ethylene glycol monobutyl ether, diethylene glycol monomethyl ether, diethylene glycol monoethyl ether, diethylene glycol monobutyl ether, tetraethylene glycol monomethyl ether, and propylene glycol monoethyl ether.

Examples of the polyvalent alcohol aryl ethers include ethylene glycol monophenyl ether and ethylene glycol monobenzyl ether.

Examples of the nitrogen-containing heterocyclic compounds include 2-pyrrolidone, N-methyl-2-pyrrolidone, N-hydroxyethyl-2-pyrrolidone, 1,3-dimethyl-2-imidazolidinone, ε-caprolactam, and γ-butyrolactone.

Examples of the amides include formamide, N-methyl formamide, N,N-dimethyl formamide, 3-methoxy-N,N-dimethyl propionamide, and 3-butoxy-N,N-dimethyl propionamide.

Examples of the amines include monoethanol amine, diethanol amine, and triethyl amine.

Examples of the sulfur-containing compounds include dimethyl sulfoxide, sulfolane, and thiodiethanol.

### - Binder-

The binder is not particularly limited and may be appropriately selected depending on the intended purpose. Examples of the binder include urethane resins, polyester resins, acrylic-based resins, vinyl acetate-based resins, styrene-based resins, butadiene-based resins, styrene-butadiene-based resins, vinyl chloride-based resins, acrylic styrene-based resins, and acrylic silicone-based resins.

When the ink contains the binder, an ink excellent in fixability and dispersibility can be obtained.

The content of the binder is not particularly limited, may be appropriately selected depending on the intended purpose, and is preferably 0.1% by mass or greater but 20% by mass or less relative to the total amount of the ink.

### -Other components-

The other components are not particularly limited and may be appropriately selected depending on the intended purpose. Examples of the other components include a surfactant, a defoaming agent, an antiseptic/fungicide, an anti-rust agent, and a pH adjustor.

The ink of the present invention can be used in coating methods such as an inkjet method, a gravure coating method, a screen printing method, a spray painting method, a spin coating method, a blade coating method, a gravure offset coating method, a bar coating method, a roll coating method, a knife coating method, an air knife coating method, a comma coating method, a U-comma coating method, an AKKU coating method, a smoothing coating method, a micro-gravure coating method, a reverse roll coating method, a 4-roll coating method, a 5-roll coating method, a dip coating method, a curtain coating method, a slide coating method, and a die coating method. Among these methods, printing methods such as an inkjet method, a gravure coating method, a screen printing method, and a spray painting method are preferable.

### (Coating film)

A coating film of the present invention contains the scaly composite particles, and further contains other components as needed.

The coating film can be formed by the coating method described method using the ink of the present invention.

It is possible to form the coating film by, for example, supplying the ink onto a substrate (for example, a glass plate) and applying the ink by the spin coating method.

Specifically, first, the ink is supplied to about the rotation center in a low-speed rotation state. Then, with the rotation speed increased, a thin film is formed on the surface of the substrate with the ink shaken off by a centrifugal force, and any residual solvent is dried. In this way, a coating film is obtained.

The rotation speed may be appropriately adjusted in a range of 300 rpm or greater but 1,000 rpm or less.

The gloss value of the coating film at an incident angle of 20° is preferably 90 or higher and more preferably 200 or higher.

When the gloss value of the coating film at an incident angle of 20° is 90 or higher, the coating film has a high specularity and an excellent metallic gloss.

The gloss value of the coating film can be measured with, for example, a gloss meter according to a collimated light method compliant with JIS Z8741 "Specular gloss measuring method" at an incident angle of 20°.

### (Printed matter)

A printed matter of the present invention includes a base, and a coating film on the base. The coating film contains scaly composite particles containing an indium layer and a transparent inorganic layer on at least one surface of the indium layer. The transparent inorganic layer is an inorganic oxide, and has an average thickness of less than 25 nm. The scaly composite particles have a cumulative 50% volume-based particle diameter D₅₀ of 1 µm or greater but 20 µm or less.

It is possible to obtain the printed matter of the present invention by printing the ink of the present invention on the base by the printing method described above.

The coating film is provided on the base. The base is not particularly limited and may be appropriately selected depending on the intended purpose. Examples of the base include plain paper, gloss paper, special paper, cloth, films, OHP sheets, general-purpose printing paper, interior and exterior parts of automobiles, home appliances, and building materials.

### (Applications)

The scaly composite particles of the present invention have a large particle diameter, are free of coloring, and can produce a printed matter having an excellent metallic gloss. Therefore, the scaly composite particles can be widely used in various fields. For example, the scaly composite particles can be used in glitter inks for inkjet or other types of printing, glitter paints for, for example, interior and exterior parts of automobiles, home appliances, and building materials, electrically conductive pigments for electrically conductive pastes, glitter pigments for imparting a metallic gloss to decorative films, glitter pigments used in metallic filaments for 3D printers, and glitter pigments to be kneaded into metallic gloss sheets or films in melt extrusion and casting.

### Examples

The present invention will be described below by way of Examples. However, the present invention should not be construed as being limited to these Examples.

### (Example 1)

A solution containing cellulose acetate butyrate (CAB) (5% by mass) was coated on a polyethylene terephthalate (PET) film having an average thickness of 25 µm by a gravure coating method in a coating amount of 0.06 g/m² ± 0.01 g/m², and dried at from 110°C through 120°C, to form a release layer.

Next, indium was vapor-deposited on the release layer by an electron beam heating/vacuum vapor deposition method at a vapor deposition rate of 3 nm/sec, to form an indium layer having an average thickness of 20 nm. The average thickness of the indium layer was a value obtained by measuring the thickness of the indium layer at five positions thereof by a quantitative analysis employing a fluorescent X-ray analysis method (XRF), and averaging the measurements.

Next, SiOₓ was vapor-deposited on the indium layer by an electron beam heating/vacuum vapor deposition method at a vapor deposition rate of 2 nm/sec, to form a transparent inorganic layer having an average thickness of 5 nm and formed of SiOₓ (where x is 2 or less).

In the way described above, a release layer, and a laminate including the indium layer and the transparent inorganic layer formed of SiOₓ were obtained on the PET film. The method for obtaining the average thickness of the transparent inorganic layer is the same as the method for obtaining the average thickness of the indium layer. The results of the average thickness of the indium layer and the transparent inorganic layer are presented in Table 1-1 and Table 1-2.

Next, butyl acetate was sprayed on the surface of the PET film on which the release layer and the laminate were formed, to dissolve the release layer. The laminate was scraped off using a doctor blade.

Next, the mixture of the obtained laminate and butyl acetate was ground with ultrasonic waves until an intended particle diameter was obtained, and then scaly composite particles 1 were recovered using a centrifuge.

### (Example 2)

Scaly composite particles 2 were obtained in the same manner as in Example 1, except that unlike in Example 1, the transparent inorganic layer formed of SiOₓ was formed to have an average thickness of 10 nm. The average thickness of each of the indium layer and the transparent inorganic layer of the obtained scaly composite particles 2 was measured in the same manner as in Example 1. The results are presented in Table 1-1 and Table 1-2.

### (Example 3)

Scaly composite particles 3 were obtained in the same manner as in Example 1, except that unlike in Example 1, the transparent inorganic layer formed of SiOₓ was formed to have an average thickness of 18 nm. The average thickness of each of the indium layer and the transparent inorganic layer of the obtained scaly composite particles 3 was measured in the same manner as in Example 1. The results are presented in Table 1-1 and Table 1-2.

### (Example 4)

Scaly composite particles 4 were obtained in the same manner as in Example 1, except that unlike in Example 1, SiOₓ of the transparent inorganic layer was changed to SiO₂. The average thickness of each of the indium layer and the transparent inorganic layer of the obtained scaly composite particles 4 was measured in the same manner as in Example 1. The results are presented in Table 1-1 and Table 1-2.

### (Example 5)

Scaly composite particles 5 were obtained in the same manner as in Example 1, except that unlike in Example 1, SiOₓ of the transparent inorganic layer was changed to ZnS. The average thickness of each of the indium layer and the transparent inorganic layer of the obtained scaly composite particles 5 was measured in the same manner as in Example 1. The results are presented in Table 1-1 and Table 1-2.

### (Example 6)

Scaly composite particles 6 were obtained in the same manner as in Example 1, except that unlike in Example 1, SiOₓ of the transparent inorganic layer was changed to Al₂O₃. The average thickness of each of the indium layer and the transparent inorganic layer of the obtained scaly composite particles 6 was measured in the same manner as in Example 1. The results are presented in Table 1-1 and Table 1-2.

### (Example 7)

Scaly composite particles 7 were obtained in the same manner as in Example 1, except that unlike in Example 1, SiOₓ was vapor-deposited on the release layer to form a first transparent inorganic layer having an average thickness of 12 nm, indium was vapor-deposited on the first transparent inorganic layer to form an indium layer having an average thickness of 20 nm, and SiOₓ was vapor-deposited on the indium layer to form a second transparent inorganic layer having an average thickness of 12 nm. The average thickness of each of the indium layer and the transparent inorganic layers of the obtained scaly composite particles 7 was measured in the same manner as in Example 1. The results are presented in Table 1-1 and Table 1-2.

### (Example 8)

Scaly composite particles 8 were obtained in the same manner as in Example 7, except that unlike in Example 7, the average thickness of the first and second transparent inorganic layers was changed to 7 nm. The average thickness of each of the indium layer and the transparent inorganic layers of the obtained scaly composite particles 8 was measured in the same manner as in Example 1. The results are presented in Table 1-1 and Table 1-2.

### (Example 9)

Scaly composite particles 9 were obtained in the same manner as in Example 1, except that unlike in Example 1, SiOₓ was vapor-deposited on the release layer to form a transparent inorganic layer having an average thickness of 7 nm, and indium was vapor-deposited on the transparent inorganic layer to form an indium layer having an average thickness of 20 nm. The average thickness of each of the indium layer and the transparent inorganic layer of the obtained scaly composite particles 9 was measured in the same manner as in Example 1. The results are presented in Table 1-1 and Table 1-2.

### (Example 10)

Scaly composite particles 10 were obtained in the same manner as in Example 9, except that unlike in Example 9, the average thickness of the transparent inorganic layer was changed to 12 nm. The average thickness of each of the indium layer and the transparent inorganic layer of the obtained scaly composite particles 10 was measured in the same manner as in Example 1. The results are presented in Table 1-1 and Table 1-2.

### (Comparative Example 1)

Scaly composite particles 11 were obtained in the same manner as in Example 1, except that unlike in Example 1, the average thickness of the transparent inorganic layer was changed to 25 nm. The average thickness of each of the indium layer and the transparent inorganic layer of the obtained scaly composite particles 11 was measured in the same manner as in Example 1. The results are presented in Table 1-1 and Table 1-2.

### (Comparative Example 2)

Scaly composite particles 12 were obtained in the same manner as in Example 7, except that unlike in Example 7, the average thickness of the first and second transparent inorganic layers was changed to 25 nm. The average thickness of each of the indium layer and the transparent inorganic layers of the obtained scaly composite particles 12 was measured in the same manner as in Example 1. The results are presented in Table 1-1 and Table 1-2.

Next, various properties of the obtained scaly composite particles were evaluated in the manners described below. The results are presented in Table 1-1 and Table 1-2.

### <Cumulative 50% volume-based particle diameter D₅₀>

As regards the cumulative 50% volume-based particle diameter D₅₀ of each kind of scaly composite particles, a sample containing each kind of scaly composite particles was delivered to a measuring cell while being stirred with a stirrer in ethanol (product name: EKINEN F-1, obtained from Japan Alcohol Trading Co., Ltd., with a refractive index of 1.360) serving as a dispersion medium, to measure the cumulative 50% volume-based particle diameter D₅₀ of the scaly composite particles with a laser diffraction/scattering particle size analyzer (instrument name: LASER MICRON SIZER LMS-2000E, obtained from Seishin Enterprise Co., Ltd., a wet dispersing unit).

### <Arithmetic means roughness Ra>

The arithmetic mean roughness Ra of the surface of the transparent inorganic layer of each kind of scaly composite particles within a range of 30 µm × 30 µm was calculated using a scanning probe microscope (AFM, obtained from Shimadzu Corporation, SPM-9600).

### <Coloring>

Coloring of each kind of scaly composite particles was visually observed to see whether the scaly composite particles were colored in, for example, red or blue. When the scaly composite particles were colored, the rating was B. When the scaly composite particles were not colored, the rating was A.

### (Examples 11 to 20 and Comparative Examples 3 and 4)

### <Ink preparation>

Using each kind of scaly composite particles obtained, the components were mixed and stirred according to the composition described below, to prepare inks used in Examples 11 to 20 and Comparative Examples 3 and 4.

### <<Ink composition>>

- Scaly composite particles: 20 parts by mass
- Binder (acrylic resin, FC-20, obtained from Mitsuwa Chemical Lab. Co., Ltd.): 20 parts by mass
- Organic solvent (butyl acetate, obtained from Daishin Chemical Co., Ltd.): 80 parts by mass

### <Formation of coating film>

After a 40 mm × 40 mm pattern was formed on a glass substrate (76 mm × 52 mm) using a scotch tape having a tape thickness of 50 µm, each ink was coated using a doctor blade, and the tape was released. The obtained film was dried and cured at 120°C for 30 minutes, to produce each coating film.

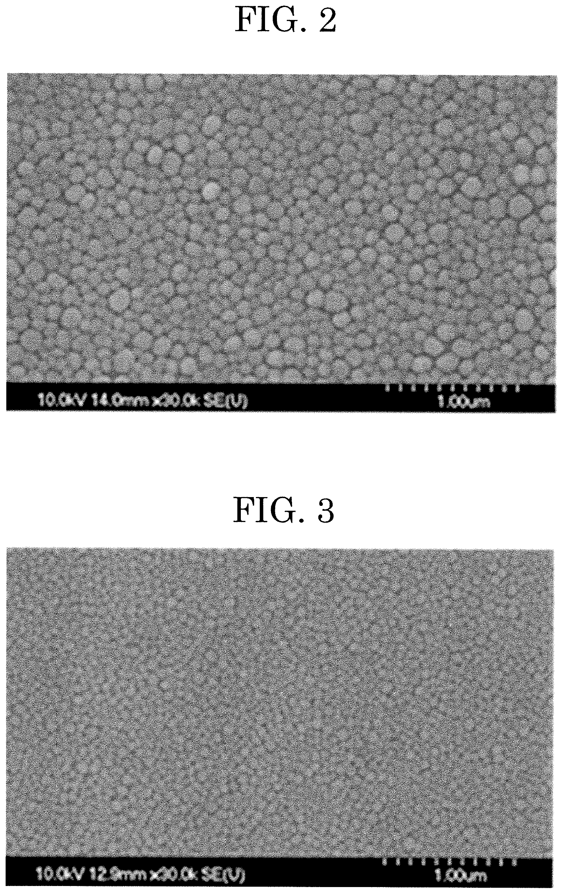

FIG. 2 to FIG. 4 illustrate SEM images of the coating films of Examples 11, 17, and 19 (at a magnification of ×30,000).

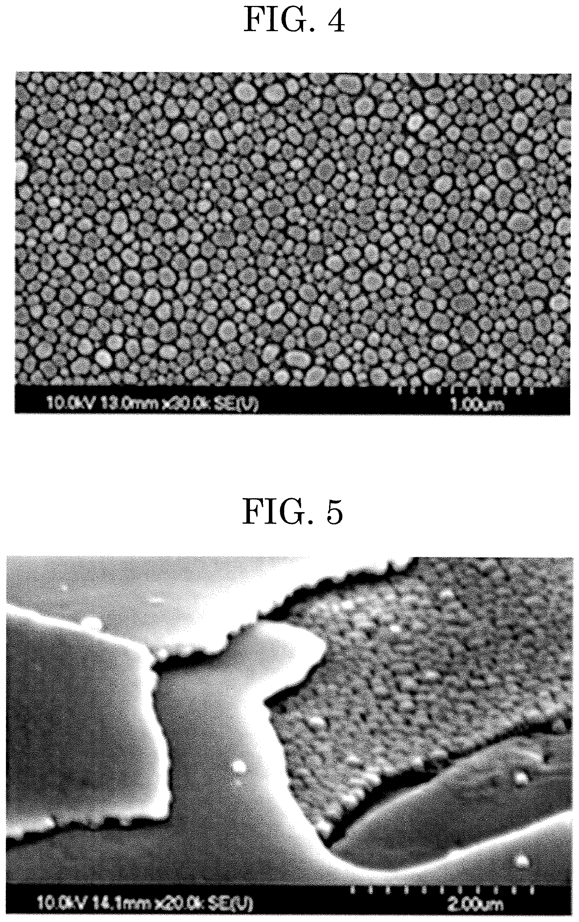

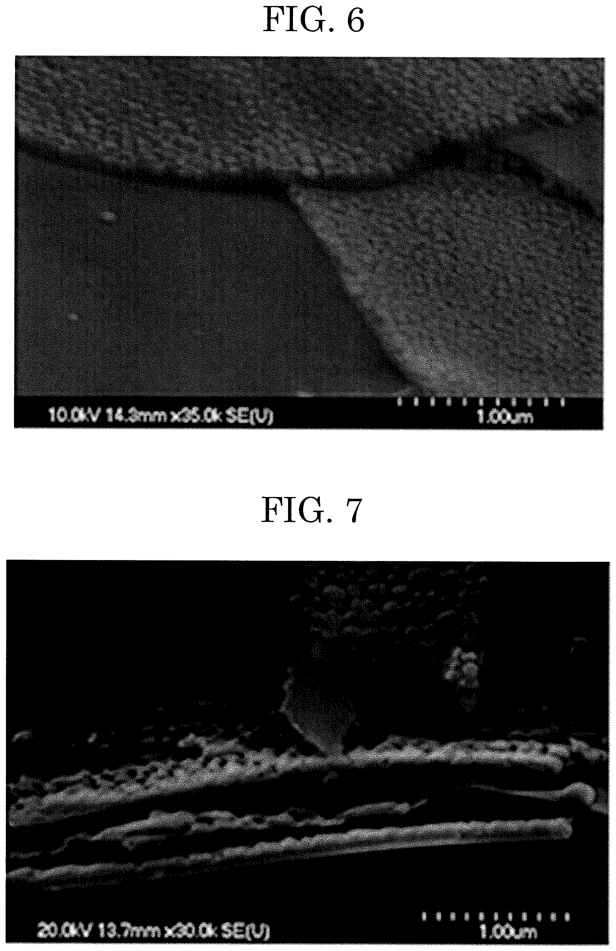

A surface of the coating product that appeared when the coating product was broken together with the base material was polished, to process the cross-section of the coating film. FIG. 5 to FIG. 7 illustrate SEM images of the cross-sections of the coating films of Examples 11, 17, and 19 (at a magnification of ×30,000).

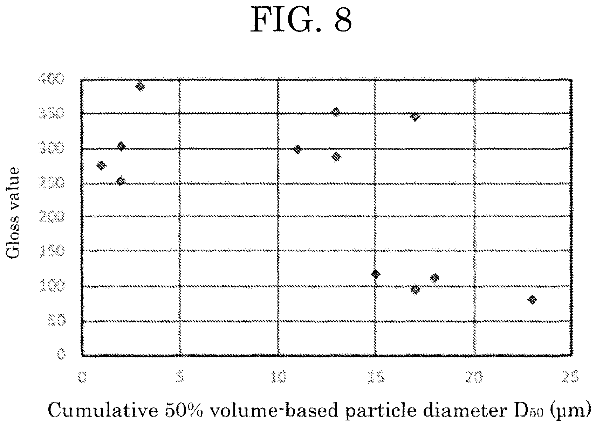

Various properties of the obtained coating films were evaluated in the manners described below. The results are presented in Table 2 and FIG. 8.

### <Gloss value>

The specular gloss of each coating film was measured. The gloss value was measured with a gloss meter (obtained from Nippon Denshoku Industries Co., Ltd., VG-7000) according to a collimated light method compliant with JIS Z8741 "Specular gloss measuring method" at an incident angle of 20° (Gs20°).

**Table 1-1**

| | Scaly composite particles No. | Order of lamination | Configuration of laminate | Average thickness of transparent inorganic layer [nm] | Average thickness of indium layer [nm] |
|---|---|---|---|---|---|
| Ex. 1 | 1 | Base material/release layer/In/SiOₓ | In/SiOx | - | 20 |
| Ex. 2 | 2 | Base material/release layer/In/SiOₓ | In/SiOx | - | 20 |
| Ex. 3 | 3 | Base material/release layer/In/SiOₓ | In/SiOx | - | 20 |
| Ex. 4 | 4 | Base material/release layer/In/SiO₂ | In/SiO₂ | - | 20 |
| Ex. 5 | 5 | Base material/release layer/In/ZnS | In/ZnS | - | 20 |
| Ex. 6 | 6 | Base material/release layer/In/Al₂O₃ | In/Al₂O₃ | - | 20 |
| Ex. 7 | 7 | Base material/release layer/SiOx/In/SiOₓ | SiOₓ/In/SiOₓ | 12 | 20 |
| Ex. 8 | 8 | Base material/release layer/SiOx/In/SiOx | SiOx/In/SiOx | 7 | 20 |
| Ex. 9 | 9 | Base material/release layer/SiOₓ/In | SiOx/In | 7 | 20 |
| Ex. 10 | 10 | Base material/release layer/SiOₓ/In | SiOx/In | 12 | 20 |
| Comp. Ex. 1 | 11 | Base material/release layer/In/SiOₓ | In/SiOₓ | - | 20 |
| Comp. Ex. 2 | 12 | Base material/release layer/SiOx/In/SiOx | SiOx/In/SiOx | 25 | 20 |

**Table 1-2**

| | Scaly composite particles No. | Average thickness of transparent inorganic layer [nm] | Cumulative 50% volume-based particle diameter D₅₀ [µm] | Arithmetic mean roughness Ra [nm] | Coloring |
|---|---|---|---|---|---|
| Ex. 1 | 1 | 5 | 2 | 10.5 | A |
| Ex. 2 | 2 | 10 | 13 | 7.4 | A |
| Ex. 3 | 3 | 18 | 1 | 7.5 | A |
| Ex. 4 | 4 | 6 | 17 | 7.2 | A |
| Ex. 5 | 5 | 21 | 18 | 10.5 | A |
| Ex. 6 | 6 | 17 | 15 | 7.9 | A |
| Ex. 7 | 7 | 12 | 3 | 7.5 | A |
| Ex. 8 | 8 | 7 | 17 | 7.6 | A |
| Ex. 9 | 9 | - | 2 | 10.7 | A |
| Ex. 10 | 10 | - | 11 | 7.5 | A |
| Comp. Ex. 1 | 11 | 25 | 23 | 7.4 | B |
| Comp. Ex. 2 | 12 | 25 | 13 | 7.5 | B |

**Table 2**

| | Scaly composite particles No. | Gloss value |
|---|---|---|
| Ex. 11 | 1 | 253 |
| Ex. 12 | 2 | 287 |
| Ex. 13 | 3 | 274 |
| Ex. 14 | 4 | 94 |
| Ex. 15 | 5 | 111 |
| Ex. 16 | 6 | 117 |
| Ex. 17 | 7 | 389 |
| Ex. 18 | 8 | 345 |
| Ex. 19 | 9 | 303 |
| Ex. 20 | 10 | 298 |
| Comp. Ex. 3 | 11 | 80 |
| Comp. Ex. 4 | 12 | 351 |

FIG. 8 is a correlation chart between the obtained gloss values and the cumulative 50% volume-based particle diameters D₅₀ of the scaly composite particles. As described above, when the gloss value of a coating film at an incident angle of 20° was 90 or higher, the coating film had a high specularity and an excellent metallic gloss. As apparent from FIG. 8, it can be seen that a gloss value range of 90 or higher fell within a cumulative 50% volume-based particle diameter D₅₀ range of 1 µm or greater but 20 µm or less.

### Reference Signs List

1: Scaly composite particles
11: Base material
12: Release layer
13: Indium layer
14: Transparent inorganic layer
15: First transparent inorganic layer
16: Second transparent inorganic layer

## Claims

1. Scaly composite particles, comprising:
an indium layer; and
a transparent inorganic layer on at least one surface of the indium layer,
wherein the transparent inorganic layer is an inorganic oxide, and has an average thickness of less than 25 nm, and
the scaly composite particles have a cumulative 50% volume-based particle diameter D₅₀ of 1 µm or greater but 20 µm or less.

2. The scaly composite particles according to claim 1,
wherein an arithmetic mean roughness Ra of a surface of the transparent inorganic layer is 15 nm or less.

3. The scaly composite particles according to claim 1 or 2,
wherein the inorganic oxide is silicon oxide.

4. The scaly composite particles according to any one of claims 1 to 3,
wherein the indium layer has a sea-island structure, and has an average thickness of 10 nm or greater but 100 nm or less.

5. A method for producing scaly composite particles, the method comprising:
forming a release layer on a base material, obtaining a laminate on the release layer, the laminate including: an indium layer; and a transparent inorganic layer laminated on at least one surface of the indium layer by a vapor deposition method, subsequently releasing the laminate from the base material, and grinding the laminate, to thereby produce scaly composite particles in which the transparent inorganic layer is an inorganic oxide and has an average thickness of less than 25 nm, the scaly composite particles having a cumulative 50% volume-based particle diameter D₅₀ of 1 µm or greater but 20 µm or less.

6. The method for producing scaly composite particles according to claim 5,
wherein in obtaining the laminate, the indium layer is formed on the release layer, and the transparent inorganic layer is laminated on a surface of the indium layer by the vapor deposition method.

7. The method for producing scaly composite particles according to claim 5,
wherein in obtaining the laminate, the transparent inorganic layer is formed on the release layer by the vapor deposition method, and the indium layer is laminated on a surface of the transparent inorganic layer.

8. The method for producing scaly composite particles according to claim 5,
wherein in obtaining the laminate, a first transparent inorganic layer is formed on the release layer by the vapor deposition method, the indium layer is formed on the first transparent inorganic layer, and a second transparent inorganic layer is formed on the indium layer by the vapor deposition method.

9. The method for producing scaly composite particles according to any one of claims 5 to 8,
wherein the vapor deposition method is a physical vapor deposition method.

10. An ink, comprising:
the scaly composite particles according to any one of claims 1 to 4.

11. The ink according to claim 10,
wherein the ink is used in any printing method selected from the group consisting of an inkjet method, a gravure coating method, a screen printing method, and a spray painting method.

12. A coating film, comprising:
scaly composite particles, where the scaly composite particles comprise:
an indium layer; and
a transparent inorganic layer on at least one surface of the indium layer,
wherein the transparent inorganic layer is an inorganic oxide, and has an average thickness of less than 25 nm, and
the scaly composite particles have a cumulative 50% volume-based particle diameter D₅₀ of 1 µm or greater but 20 µm or less.

13. A printed matter, comprising:
a base; and
the coating film according to claim 12 on the base.
